# EUROPÄISCHE PATENTSCHRIFT

(11) **EP 1 595 002 B1**
(45) Veröffentlichungstag und Bekanntmachung des Hinweises auf die Patenterteilung: **10.09.2008**
(21) Anmeldenummer: 04704605.7
(22) Anmeldetag: 23.01.2004
(51) Int. Cl.: C23C 14/08, C01F 17/00, C04B 35/64, C04B 35/50, C04B 35/622, B32B 18/00, G02B 1/10, C03C 17/245

(54) **AUFDAMPFMATERIAL ZUR HERSTELLUNG HOCHBRECHENDER OPTISCHER SCHICHTEN**
VAPORIZING MATERIAL FOR PRODUCING HIGHLY REFRACTIVE OPTICAL LAYERS
MATIERE DE VAPORISATION POUR PRODUIRE DES COUCHES OPTIQUES A HAUTE REFRACTION

(30) Priorität: 19.02.2003 DE 10307117
(43) Veröffentlichungstag der Anmeldung: 16.11.2005
(73) Patentinhaber: Merck Patent GmbH, 64293 Darmstadt (DE)
(72) Erfinder: FRIZ, Martin, 64297 Darmstadt (DE); DOMBROWSKI, Reiner, 64739 Höchst (DE); ANTHES, Uwe, 64711 Erbach (DE)
(86) Internationale Anmeldenummer: PCT/EP2004/000553
(87) Internationale Veröffentlichungsnummer: WO 2004/074539

(56) Entgegenhaltungen:
- EP-A- 1 020 416
- GB-A- 1 162 822
- US-A- 4 501 799
- PATENT ABSTRACTS OF JAPAN vol. 013, no. 328 (C-621), 24. Juli 1989 (1989-07-24) & JP 01 108124 A (NATL INST FOR RES IN INORG MATER), 25. April 1989 (1989-04-25)

## Beschreibung

Die Erfindung betrifft ein Aufdampfmaterial zur Erzeugung hochbrechender optischer Schichten, welches Titanoxid im Gemisch mit Gadoliniumoxid und/oder Dysprosiumoxid enthält.

Optische Bauteile werden gewöhnlich mit dünnen Beschichtungen versehen, welche zum Schutz der Oberflächen oder zur Erzielung bestimmter optischer Eigenschaften aufgebracht werden.

Bei derartigen optischen Bauteilen handelt es sich beispielsweise um optische Linsen, Brillengläser, Objektive für Kameras, Ferngläser oder für andere optische Geräte, um Strahlteiler, Prismen, Spiegel, Fensterscheiben und dergleichen.
Die Beschichtungen dienen einerseits zur Vergütung der genannten Oberflächen durch Härtung und/oder Erhöhung der chemischen Resistenz um Schädigungen durch mechanische, chemisch oder Umwelteinflüsse zu vermindern oder zu vermeiden, andererseits aber oft auch zur Erzielung einer verminderten Reflexion, was insbesondere bei Brillengläsern und Objektiven der Fall ist. Durch Auswahl geeigneter Beschichtungsmaterialien, verschiedener Schichtdicken und ein- oder mehrschichtiger Schichtaufbauten aus gegebenenfalls unterschiedlichen Materialien mit verschiedenen Brechzahlen kann dabei eine Reduktion der Reflexion auf unter 1% über das gesamte sichtbare Strahlungsspektrum erzielt werden. Durch geeignete Kombinationen von verschiedenen Materialien in geeigneten Schichtdicken können auch Interferenzspiegel, Strahlteiler, Wärmefilter oder Kaltlichtspiegel hergestellt werden.

Zur Erzeugung der oben genannten Vergütungsschichten sind verschiedene, insbesondere oxidische Materialien bekannt, wie beispielsweise SiO₂, TiO₂, ZrO₂, MgO, Al₂O₃, aber auch Fluoride wie MgF₂ sowie Gemische dieser Stoffe.

Die Auswahl der Beschichtungsmaterialien erfolgt dabei nach den angestrebten optischen Eigenschaften und nach der Verarbeitbarkeit der Materialien.

Die Beschichtung von optischen Substraten wird üblicherweise mit einem Hochvakuumaufdampfverfahren durchgeführt. Hierbei wird zunächst das Substrat und eine die Aufdampfsubstanz enthaltende Vorlage in einer geeigneten Hochvakuumaufdampfapparatur platziert, anschließend die Apparatur evakuiert und die Aufdampfsubstanz durch Erhitzen und/oder Elektronenstrahlbeschuss zur Verdampfung gebracht, wobei sich das Aufdampfmaterial als dünne Schicht auf der Substratoberfläche niederschlägt. Entsprechende Apparaturen und Verfahren sind gängiger Stand der Technik.

Die Auswahl an Ausgangsstoffen, die sich zur Herstellung von Schichten mit hoher Brechzahl, d.h. mit einer Brechzahl von 2 oder größer, eignen, ist vergleichsweise begrenzt. Im wesentlichen kommen hier die Oxide des Titans, Zirkoniums, Hafniums und Tantals sowie deren Mischoxide in Betracht. Am häufigsten wird Titanoxid eingesetzt. Die daraus hergestellten Schichten sind im sichtbaren und im nahen infraroten Spektralbereich von etwa 380 nm bis 5 µm transparent und sollten, so wie das Ausgangsmaterial, keine wesentliche Absorption aufweisen. Die mit Titanoxid bei einer Wellenlänge um 500 nm erreichbare Brechzahl liegt bei etwa 2,4. Unter UV-Bestrahlung wird jedoch Absorption beobachtet.

Auch tritt insbesondere bei reinem Titan(IV)oxid die Gefahr auf, dass es bei der Verdampfung zu einem Sauerstoffverlust kommt, welcher zur Abscheidung unterstöchiometrischer Titanoxidschichten und damit zu im sichtbaren Bereich absorbierenden Schichten führt. Dies kann durch geeignete Maßnahmen bei der Verdampfung, wie z.B. das Einstellen eines Sauerstoffrestdruckes, oder auch durch den Zusatz bestimmter Stoffe, wie beispielsweise gemäß DE-PS 12 28 489 von Elementen oder Oxiden aus der Gruppe der seltenen Erden, verhindert werden. Hier wurden unter anderem Gemische von Titanoxid mit Praseodym und/oder Praseodymoxid oder auch Gemische von Titanoxid mit Cer und/oder Ceroxid genannt.

Die relative Absorptionsfreiheit dieser bekannten Gemische beschränkt sich jedoch auf den sichtbaren Spektralbereich. Über den ultravioletten oder den nahen infraroten Spektralbereich ist dagegen in der DE-PS 12 28 489 keine Aussage getroffen worden.

Ein weiterer Nachteil der reinen Oxide besteht darin, dass sie in der Regel hohe Schmelz- und Siedepunkte aufweisen, die darüber hinaus auch noch dicht beieinander liegen. Aus verarbeitungstechnischen Gründen ist es jedoch empfehlenswert, dass die Aufdampfmaterialien vor Beginn einer merklichen Verdampfung vollständig aufgeschmolzen sind. Nur so kann eine gleichmäßige und ausreichende Abdampfrate erzielt werden, die zur Ausbildung homogener und gleichmäßig dicker Schichten erforderlich ist. Unter den üblichen Arbeitsbedingungen treten jedoch insbesondere bei den Oxiden des Zirkons und Hafniums, wie auch bei Titan-Zirkon-Mischoxiden Schwierigkeiten bezüglich des Aufschmelzens ein.
Die entstehenden Schichten sind oft optisch inhomogen und führen bei der üblichen Mehrfachaufbringung zu Schwierigkeiten bei der Reproduzierbarkeit der Brechzahlen.

Aus diesem Grunde werden den reinen Metalloxiden auch Materialien zugesetzt, welche den Schmelzpunkt des Metalloxids herabsetzen sollen und unter anderem auch zur gezielten Variation der Brechzahlen eingesetzt werden. Diese Materialien sind jedoch so auszuwählen, dass es bei den ausgebildeten Schichten zu keiner merklichen Absorption im sichtbaren Bereich kommt.

Es hat sich jedoch als nachteilig herausgestellt, dass Gemische der oben genannten Metalloxide mit den Schmelzpunkt herabsetzenden Zusätzen inkongruent verdampfen, d.h. dass sie im Verlaufe des Verdampfungsprozesses ihre Zusammensetzung verändern und entsprechend auch die Zusammensetzung der abgeschiedenen Schicht verändert wird.

Zur Lösung dieses Problems wurden Mischoxide wie beispielsweise La₂Ti₂O₇ vorgeschlagen. Diese geben jedoch beim Verdampfen, ähnlich wie Titan(IV)oxid, Sauerstoff ab, so dass es zu unterstöchiometrischer Zusammensetzung der abgeschiedenen Schichten und damit zu Absorptionserscheinungen kommt.

Außer den oben bereits genannten Metalloxiden, welche sich für die Herstellung hochbrechender Schichten eignen, sind auch in anderen Veröffentlichungen bereits Oxide der seltenen Erdmetalle genannt worden.

So sind zum Beispiel Mischungen aus Praseodymoxid und Titandioxid bekannt. Diese weisen im Spektralbereich von kleiner als 400 nm eine starke und im sichtbaren Spektralbereich eine schwache Absorption auf, welche durch die Absorption des Praseodym-Ions verursacht wird.

Auch sind bereits mehrfach Gemische aus Lanthanoxid und Titanoxid, beispielsweise in DE 42 08 811 sowie in DE 100 65 647, vorgeschlagen worden. Der Anteil an Lanthanoxid führt jedoch bei den damit erzeugten Schichten zu einer erhöhten Empfindlichkeit gegenüber Feuchtigkeit. Zusätzlich kann das natürliche radioaktive Isotop des Lanthans durch seine radioaktive Strahlung an empfindlichen optischen Bauteilen zu Schädigungen führen.

In der US 4,794,607 ist der Einsatz von Gadoliniumoxidschichten im Wechsel mit Aluminiumoxidschichten beschrieben, die als Antireflexionsbeschichtung für einen optischen Verstärker dienen. Untersuchungen an diesem Material haben ergeben, dass mit Gadoliniumoxid homogene Schichten durch Aufdampfen erhalten werden können, die je nach der Art ihrer Aufbringung Brechzahlen von 1,75 oder 1,80 aufweisen (K. Truszkowska, C. Wesolowska, "Optical properties of evaporated gadolinium oxide films in the region 0.2-5 µm", Thin Solid Films (1976), 34(2), 391-4). Damit sind die erzeugten Schichten von einer angestrebten Brechzahl von 2 oder größer weit entfernt.

Aus der DE-OS 3335557 ist es bekannt, abwechselnd Schichten aus Titandioxid und Ytterbiumoxid oder Schichtfolgen aus Aluminiumoxid und Ytterbiumoxid zur Erzeugung von Antireflexionsbeschichtungen auf optischen Linsen zu verwenden.
Von Ytterbiumoxid ist bekannt, dass es je nach Dicke der aufgetragenen Schichten und abhängig vom Auftragsverfahren Brechzahlen von 1,75 bis 1,9 erzielen kann. Auch diese Brechzahlen liegen nicht im hochbrechenden Bereich.

Weiterhin sind auch Gemische aus Titanoxid mit Dysprosiumoxid und/oder Ytterbiumoxid bekannt, welche aber nach WO 95/05670 zur Erzeugung halbleitender Metalloxidschichten im Sol/Gel-Verfahren auf Photovoltaikzellen aufgebracht werden.
Über erzielbare Brechzahlen der erzeugten Schichten wird nichts ausgesagt.

Es war daher die Aufgabe der vorliegenden Erfindung, ein Aufdampfmaterial zur Herstellung von Schichten mit einer hohen Brechzahl von mindestens 2,0 zur Verfügung zu stellen, welches eine hohe Haltbarkeit aufweist, gegen Feuchtigkeit, Säuren und Alkalien wenig empfindlich ist, eine geringe Radioaktivität besitzt, über einen breiten Spektralbereich transparent und nicht absorbierend ist und beim Einschmelzen und Verdampfen seine ursprüngliche Zusammensetzung nicht verändert und welches zur Herstellung hochbrechender Schichten mit den gleichen Eigenschaften geeignet ist.

Diese Aufgabe wird gemäß der vorliegenden Erfindung durch ein Aufdampfmaterial zur Herstellung hochbrechender optischer Schichten, enthaltend Titanoxid, Titan und Gadoliniumoxid und/oder Dysprosiumoxid, gelöst.

Die erfindungsgemäße Aufgabe wird weiterhin gelöst durch ein Verfahren zur Herstellung eines Aufdampfmaterials zur Erzeugung hochbrechender optischer Schichten, wobei Titanoxid mit Gadoliniumoxid und/oder Dysprosiumoxid gemischt, die Mischung komprimiert oder suspendiert, geformt und anschließend gesintert wird und wobei der Mischung zusätzlich Titan zugesetzt wird.

Gegenstand der Erfindung ist darüber hinaus die Verwendung eines Aufdampfmaterials enthaltend Titanoxid und Gadoliniumoxid und/oder Dysprosiumoxid zur Herstellung hochbrechender optischer Schichten.

Schließlich ist die Erfindung auf ein mehrlagiges optisches System nach Anspruch 23 gerichtet.

Ein Aufdampfmaterial für die erfindungsgemäße Verwendung enthält Titandioxid und Gadoliniumoxid (Gd₂O₃) und/oder Dysprosiumoxid (Dy₂O₃). Diese Materialien können in einem molaren Verhältnis von 4:1 bis 1:4 vorliegen, wobei sich die jeweils letzte Zahl auf den molaren Anteil von Gadoliniumoxid oder Dysprosiumoxid oder auf die Summe der molaren Anteile an Gadoliniumoxid und Dysprosiumoxid bezieht.

Bevorzugt liegen die Materialien in einem molaren Verhältnis von 2,6:1 bis 1:1,3 vor, wobei sich wiederum die letzte Zahl auf den molaren Anteil von Gadoliniumoxid oder Dysprosiumoxid oder auf die Summe der molaren Anteile an Gadoliniumoxid und Dysprosiumoxid bezieht.

Wird ein Gemisch aus Gadoliniumoxid und Dysprosiumoxid eingesetzt, so ist der jeweilige Anteil der Einzelsubstanzen untereinander an sich nicht kritisch. Er kann in einem breiten Verhältnis, insbesondere im Verhältnis von 99:1 bis 1:99 eingestellt werden.

Bezüglich der Gewichtsteile werden vorteilhafterweise die folgenden Verhältnisse eingestellt: 50 bis 92 Gewichtsteile Gadoliniumoxid und/oder Dysprosiumoxid, 7 bis 42 Gewichtsteile Titandioxid sowie 0 bis 8 Gewichtsteile Titan, bezogen auf das Gesamtgewicht der Mischung. Bevorzugt werden 67 bis 76 Gewichtsteile Gadoliniumoxid und/oder Dysprosiumoxid, 15 bis 27 Gewichtsteile Titandioxid und 2 bis 5 Gewichtsteile Titan, bezogen auf das Gesamtgewicht der Mischung, eingesetzt.

Betrachtet man die Brechzahlen, welche sich durch Beschichtungen mit den Einzelkomponenten erzielen lassen, so liegen diese bei Beschichtungen mit Titandioxid bei etwa 2,3 bis 2,4, während mit reinen Gadoliniumoxidschichten und mit reinen Dysprosiumoxidschichten Brechzahlen von etwa 1,75 bis 1,9 erhalten werden können.

In der Regel lassen sich mit Mischungen aus zwei Komponenten Schichten mit Brechzahlen erzielen, die je nach molarem Anteil der Komponenten zwischen den beiden Einzelwerten liegen. Ein relativ hoher molarer Anteil einer eher niedrig brechenden Komponente würde danach zu einer Brechzahl des Gemisches führen, die näher an der Brechzahl der niedrig brechenden Komponente liegt als an der Brechzahl der höher brechenden Komponente.

Es hat sich daher überraschend herausgestellt, dass sich mit Gemischen, welche Titandioxid und Gadoliniumoxid und/oder Dysprosiumoxid bevorzugt in den vorab beschriebenen molaren Anteilen enthalten, Schichten mit Brechzahlen erhalten lassen, welche deutlich höher als die zu erwartenden Mischwerte und insbesondere nahe an der Brechzahl von reinem Titandioxid liegen. Konkret lassen sich mit diesen Mischungen Schichten mit Brechzahlen von deutlich über 2,0, nämlich im Bereich von etwa 2,20 bis etwa 2,30, erzeugen. Dabei kann innerhalb dieses Bereiches die jeweils gewünschte definierte Brechzahl gezielt über den molaren Anteil an Gadoliniumoxid und/oder Dysprosiumoxid eingestellt werden. Ein höherer Anteil an einer oder beiden dieser Komponenten führt dann zu einer geringfügigen Absenkung der erhaltenen Brechzahl.

Werden sowohl Gadoliniumoxid als auch Dysprosiumoxid im Gemisch eingesetzt, hat dagegen der jeweilige molare Anteil dieser beiden Substanzen keinen wesentlichen Einfluß auf die Brechzahl, die mit dem Titandioxid-haltigen Gesamtgemisch erhalten werden kann. Das gilt insbesondere dann, wenn die Summe der molaren Anteile des Gemisches in den oben genannten Grenzen liegt.

Des weiteren hat sich als vorteilhaft herausgestellt, dass die erfindungsgemäßen Aufdampfmaterialien nahezu kongruent verdampfen, d.h. dass sich ihre Zusammensetzung im Verlaufe des Verdampfungsprozesses nicht wesentlich verändert. Auf diese Weise lassen sich homogene Schichten mit einer stabilen hohen Brechzahl von n ≥ 2,0, insbesondere von n ≥ 2,20 herstellen.

Die erhaltenen optischen Schichten weisen außerdem eine hohe Transparenz in einem breiten Spektralbereich auf, d.h. von etwa 380 nm bis 5 µm. Insbesondere kann im sichtbaren und im nahen infraroten Spektralbereich eine völlige Transparenz erzielt werden.

Gegenüber den aus dem Stand der Technik bekannten Aufdampfmaterialien zur Erzeugung hochbrechender Schichten weisen die aus dem erfindungsgemäßen Aufdampfmaterial hergestellten Schichten eine verbesserte Haltbarkeit auf. Dies ist insbesondere in feucht-warmer Umgebung der Fall, da die erfindungsgemäßen Aufdampfmaterialien nicht zur Aufnahme von Feuchtigkeit neigen. Diese Eigenschaft erweist sich schon bei der Herstellung der Aufdampfmaterialien als sehr vorteilhaft, da spezielle Maßnahmen bei der Handhabung und Weiterverarbeitung der Gemische ausbleiben können. Aber auch die nach der Abscheidung auf geeigneten Substraten entstehenden hochbrechenden Schichten sind in feucht-warmer Umgebung besonders stabil. Ebenso kann gegenüber Säuren und Alkalien eine verbesserte Haltbarkeit festgestellt werden.

Ein weiterer Vorteil der Aufdampfmaterialien der vorliegenden Erfindung liegt darin, dass die verwendeten Substanzen keine radioaktiven Isotope aufweisen. Weder die Aufdampfmaterialien selbst noch die damit hergestellten Schichten strahlen daher radioaktiv, so dass Vorsichtsmaßnahmen unterbleiben können und eine diesbezügliche Schädigung von optischen Bauelementen oder Detektoren, welche mit den Schichten in Verbindung kommen, nicht zu erwarten ist.

Ein weiterer Gegenstand der Erfindung ist ein Aufdampfmaterial zur Herstellung hochbrechender optischer Schichten enthaltend Titandioxid, Titan und Gadoliniumoxid (Gd₂O₃) und/oder Dysprosiumoxid (Dy₂O₃).

Durch den Zusatz von metallischem Titan im Aufdampfmaterial wird ein unterstöchiometrisches Verhältnis der Mischung bezüglich Sauerstoff eingestellt. Dadurch wird eine Abgabe von Sauerstoff während des Einschmelzens und Verdampfens der Mischung vermieden. Dies verbessert auch die Handhabbarkeit des Aufdampfmaterials, da beim Einschmelzen und Verdampfen das sonst üblicherweise auftretende Spritzen verhindert werden kann. Das Gemisch erhält auf diese Weise eine besonders stabile Zusammensetzung, die sich während des gesamten nachfolgenden Verarbeitungsprozesses nicht verändert.

Auch hier kann das molare Verhältnis von Titanoxid zu Gadoliniumoxid und/oder Dysprosiumoxid 4:1 bis 1:4, bevorzugt jedoch 2,6:1 bis 1:1,3, betragen, wobei sich die jeweils letzte Zahl auf den molaren Anteil von Gadoliniumoxid oder Dysprosiumoxid oder auf die Summe der molaren Anteile an Gadoliniumoxid und/oder Dysprosiumoxid bezieht.

Für den Fall, dass ein Gemisch aus Gadoliniumoxid und Dysprosiumoxid zum Einsatz kommt, können innerhalb des molaren Anteils der beiden Substanzen die Anteile der Einzelsubstanzen untereinander im Verhältnis 99:1 bis 1:99 variiert werden.

Als besonders vorteilhaft hat sich ein Gemisch aus Titandioxid, Titan und Dysprosiumoxid erwiesen.

Bezüglich der Gewichtsteile werden vorteilhafterweise die folgenden Verhältnisse eingestellt: 50 bis 92 Gewichtsteile Gadoliniumoxid und/oder Dysprosiumoxid, 7 bis 42 Gewichtsteile Titandioxid sowie 2 bis 8 Gewichtsteile Titan, bezogen auf das Gesamtgewicht der Mischung. Bevorzugt werden 67 bis 76 Gewichtsteile Gadoliniumoxid und/oder Dysprosiumoxid, 15 bis 27 Gewichtsteile Titandioxid und 2 bis 5 Gewichtsteile Titan, bezogen auf das Gesamtgewicht der Mischung, eingesetzt.

Bezüglich der erzielbaren Brechzahlen der mit dem Material erhaltenen optischen Schichten hat der Zusatz von metallischem Titan keine nachteiligen Auswirkungen. Auch hier können Brechzahlen von größer als 2,0 und insbesondere von 2,20 bis 2,30 erhalten werden.

Alle Vorteile, die oben bereits für die erfindungsgemäß zu verwendenden Aufdampfmaterialien ohne Titanzusatz beschrieben wurden, treffen auch auf die Gemische zu, die neben Titandioxid und Gadoliniumoxid und/oder Dysprosiumoxid noch metallisches Titan enthalten.

Die weiter oben erwähnten Vorteile bedeuten, dass die Mischungen sich gut verarbeiten lassen und damit in einem breiten Spektralbereich nicht absorbierende, transparente, homogene Schichten mit stabiler hoher Brechzahl erhalten werden, welche darüber hinaus in feucht- warmer Umgebung stabil sind und keine radioaktive Strahlung abgeben.

Die erfindungsgemäßen Aufdampfmaterialien werden hergestellt, indem Titanoxid mit Gadoliniumoxid und/oder Dysprosiumoxid gemischt, die Mischung komprimiert oder suspendiert, geformt und anschließend gesintert wird, wobei der Mischung zusätzlich Titan zugesetzt wird. Vorteilhafterweise werden Titanoxid und Gadoliniumoxid und/oder Dysprosiumoxid in einem molaren Verhältnis von 4:1 bis 1:4, und insbesondere in einem molaren Verhältnis von 2,6:1 bis 1:1,3, innig miteinander gemischt, wobei sich die jeweils letzte Zahl auf den molaren Anteil von Gadoliniumoxid oder Dysprosiumoxid oder auf die Summe der molaren Anteile an Gadoliniumoxid und/oder Dysprosiumoxid bezieht,

Das Gemisch wird mittels geeigneter, an sich bekannter Maßnahmen der Komprimierung verdichtet und geformt. Es kann jedoch auch eine Suspension der gemischten Komponenten in einem geeigneten Trägermedium hergestellt werden, welche geformt und anschließend getrocknet wird. Ein geeignetes Trägermedium ist beispielsweise Wasser, welchem je nach Bedarf Bindemittel wie Polyvinylalkohol, Methylzellulose oder Polyethylenglykol sowie gegebenenfalls Hilfsmittel, wie z.B. Netzmittel oder Entschäumer, zugesetzt werden. Nach dem Suspendieren erfolgt eine Formgebung. Hierbei können verschiedene bekannte Techniken, wie Strangpressen, Spritzgießen oder auch Sprühtrocknen Anwendung findet. Die erhaltenen Formen werden getrocknet und vom Bindemittel, beispielsweise durch Ausbrennen, befreit. Dies erfolgt aus Gründen einer besseren Handhabbarkeit und Dosierbarkeit der Mischungen. Daher sind die Formen, in welche das Gemisch gebracht wird, nicht limitiert. Geeignet sind alle Formen, welche eine einfache Handhabung und eine gute Dosierbarkeit ermöglichen, die insbesondere bei der kontinuierlichen Beschichtung von Substraten mit dem erfindungsgemäßen Aufdampfmaterial und dem dafür nötigen Nachfüllprozeß eine besondere Rolle spielen. Bevorzugte Formen sind daher verschiedene Tablettenformen, Pellets, Scheiben, Kegelstümpfe, Körner bzw. Granulate, Stangen oder auch Kugeln.

Anschließend werden die geformten Gemische gesintert. Der Sinterprozeß kann dabei unter verschiedenen Bedingungen durchgerührt werden.

Beispielsweise kann in Luft bei Temperaturen von 1200 bis 1600 °C, unter Inertgas wie z. B. Argon bei Temperaturen von 1200 bis 1600 °C, oder im Vakuum bei Temperaturen von 1300 bis 1700 °C und einem Restdruck von unter 1 Pa gesintert werden. Dabei ist es von Vorteil, dass der Sinterprozeß nicht, wie sonst allgemein üblich, unbedingt im Vakuum durchgeführt werden muß. Dies erspart sowohl apparativen wie auch zeitlichen Aufwand.

Die entstehenden geformten Sinterprodukte bleiben in ihrer Form beim Lagern, Transportieren und beim Einfüllen in die Verdampfungsapparatur bestehen und sind in ihrer Zusammensetzung während des gesamten nachfolgenden Aufschmelz- und Verdampfungsprozesses stabil.

Vorzugsweise werden beim Mischen Gewichtsverhältnisse von 50 bis 92 Gewichtsteilen Gadoliniumoxid und/oder Dysprosiumoxid, 7 bis 42 Gewichtsteilen Titanoxid und 2 bis 8 Gewichtsteilen Titan, bezogen auf das Gesamtgewicht der Mischung, eingestellt. Besonders bevorzugt wird ein Gemisch aus 67 bis 76 Gewichtsteilen Gadoliniumoxid und/oder Dysprosiumoxid, 15 bis 27 Gewichtsteilen Titanoxid und 2 bis 5 Gewichtsteilen Titan, bezogen auf das Gesamtgewicht der Mischung, hergestellt.

Unter Einhaltung der oben genannten Mischungsverhältnisse hat sich ein Gemisch aus Dysprosiumoxid, Titandioxid und Titan als besonders vorteilhaft erwiesen.

Nach dem Sintern und Abkühlen ist das erfindungsgemäße Aufdampfmaterial anwendungsbereit zur Herstellung von hochbrechenden optischen Schichten mit einer Brechzahl von n ≥ 2,0, insbesondere n ≥ 2,20.

Es lassen sich alle geeigneten Substrate mit dem erfindungsgemäßen Aufdampfmaterial beschichten, insbesondere Scheiben, Prismen, Folien, geformte Substrate wie optische Linsen, Brillengläser und Objektive und dergleichen, welche aus den bekannten geeigneten Materialien wie verschiedenen Gläsern oder Kunststoffen bestehen können. Bezüglich Art, Größe, Form, Material und Oberflächenbeschaffenheit der zu beschichten-den Substrate ist die Anwendung der erfindungsgemäßen Aufdampfmaterialien daher keinerlei Beschränkungen unterworfen, sofern die Substrate in die Vakuumapparatur eingebracht werden können und bei den herrschenden Temperatur- und Druckverhältnissen stabil bleiben. Es hat sich jedoch als vorteilhaft herausgestellt, die Substrate zur Erhöhung der Dichte der aufgebrachten Schichten vor und während des Beschichtens zu erwärmen, so dass das Aufdampfmaterial auf ein vorgeheiztes Substrat trifft. Je nach Art der eingesetzten Substrate wird dabei auf Temperaturen bis 300°C erwärmt. Diese Maßnahme an sich ist jedoch bekannt.

Als Aufdampfverfahren wird üblicherweise ein Hochvakuumaufdampfverfahren eingesetzt, bei welchem das Aufdampfmaterial in einer geeigneten Vorlage, welche auch als Verdampfungstiegel oder -schiffchen bezeichnet wird, zusammen mit dem zu beschichtenden Substrat in eine Vakuumapparatur eingebracht wird.

Anschließend wird die Apparatur evakuiert und das Aufdampfmaterial durch Erhitzen und/oder Elektronenstrahlbeschuß zur Verdampfung gebracht. Dabei schlägt sich das Aufdampfmaterial als dünne Schicht auf dem Substrat nieder.

Während der Verdampfung wird vorteilhafterweise Sauerstoff zugesetzt, um die volle Oxidation der Schichten zu gewährleisten. Zur Verbesserung der Haftung der aufgebrachten Schichten auf insbesondere ungeheizten Substraten kann das Substrat während der Beschichtung mit Ionen beschossen werden (Ion Assisted Deposition, Plasma Assisted Deposition).

In der Regel werden abwechselnd mehrere Schichten übereinander abgeschieden, die zweckmäßigerweise abwechselnd hohe und niedrige (n ≤ 1,80) Brechzahlen aufweisen. Auf diese Weise entstehen mehrlagige Anordnungen, welche den damit beschichteten Substraten unter anderem eine stark verminderte Reflexion verleihen können. Solche mehrlagigen Anordnungen auf optischen Substraten an sich sind jedoch seit langem bekannt und werden häufig angewendet.

Mit den erfindungsgemäßen Aufdampfmaterialien lassen sich haftfeste hochbrechende optische Schichten auf geeigneten Substraten herstellen, welche in einem breiten Spektralbereich nicht absorbierend, transparent und homogen sind, eine hohe Brechzahl von insbesondere n ≥ 2,20 aufweisen, in feucht- warmer Umgebung sowie gegenüber Säuren und Alkalien stabil sind und keine radioaktive Strahlung abgeben.

Die Erfindung soll nachfolgend durch mehrere Beispiele erläutert werden, ohne sie jedoch darauf zu beschränken.

### Beispiel 1:

### Mischung aus Dy₂O₃ und TiO₂

68,3 Gew. % Dy₂O₃ und 31,7 Gew. % Titandioxid werden innig miteinander vermischt und anschließend zu Tabletten geformt. Diese werden an Luft bei etwa 1500 °C 4 Stunden lang geglüht. Die Tabletten werden anschließend in eine Aufdampfanlage mit Elektronenstrahl-Verdampfereinrichtung, beispielsweise vom Typ A700Q der Fa. Leybold, eingebracht und bei Temperaturen von etwa 2000°C und einem Sauerstoffdruck von 2x10⁻² Pa verdampft. Dabei wird auf den als Substraten in der Apparatur befindlichen Gläsern aus Quarzglas, welche vor der Bedampfung auf etwa 300 °C erhitzt worden waren, eine dünne Schicht abgeschieden. Die Dicke dieser Schicht wird auf etwa 340 nm eingestellt. Nach dem Abkühlen und der Entnahme aus der Verdampfungsapparatur werden die Transmissions-und Reflexionsspektren der beschichteten Gläser mit einem Spektralphotometer gemessen. Aus den Spektren wird die Brechzahl der Schicht ermittelt. Es werden homogene Schichten erhalten, welche bei einer Wellenlänge von 500 nm eine Brechzahl von 2,28 aufweisen.
Die Schichten sind im Spektralbereich von 400 nm bis etwa 5 µm transparent und weisen in diesem Bereich keine Absorption auf. Die Schichten sind in feucht-warmer Atmosphäre, z. B. bei 80% relativer Luftfeuchte und 50°C, haltbar und besitzen eine gute Härte und Haftfestigkeit.
Die beschichteten Substrate werden 10 Minuten in voll entsalztem (VE) Wasser gekocht, 6 Stunden bei Raumtemperatur in einer 4,5 Gew. % Kochsalzlösung in VE-Wasser sowie 6 Stunden bei Raumtemperatur in einer 0,01 molaren Salzsäurelösung gelagert. Bei keinem der Mustergläser ist nach dem jeweiligen Test eine Ablösung der aufgebrachten Schicht zu beobachten. Flecken und/oder Trübungen sind nicht feststellbar.

### Beispiel 2:

### Mischung aus Dy₂O₃, TiO₂ und Ti

Aus einer homogenen Mischung aus 71,03 Gew. % Dy₂O₃, 26,20 Gew. % Titandioxid und 2,77 Gew. % Titan werden Tabletten hergestellt und diese nachfolgend im Vakuum bei einem Druck von 1x10⁻¹ Pa bei etwa 1600 °C 10 Stunden lang geglüht.
Die Tabletten werden anschließend in eine Aufdampfanlage mit Elektronenstrahl-Verdampfereinrichtung vom Typ A700Q der Fa. Leybold eingebracht und bei Temperaturen von etwa 2000°C und einem Sauerstoffdruck von 2x10⁻² Pa verdampft. Dabei wird auf den als Substraten in der Apparatur befindlichen Gläsern aus Quarzglas, welche vor der Bedampfung auf etwa 300 °C erhitzt worden waren, eine dünne Schicht abgeschieden. Die Dicke dieser Schicht wird auf etwa 340 nm eingestellt. Nach dem Abkühlen und der Entnahme aus der Verdampfungsapparatur werden die Transmissions- und Reflexionsspektren der beschichteten Gläser mit einem Spektralphotometer gemessen. Aus den Spektren wird die Brechzahl der Schicht ermittelt. Es werden homogene Schichten erhalten, welche bei einer Wellenlänge von 500 nm eine Brechzahl von 2,25 aufweisen.
Die Schichten sind im Spektralbereich von 400 nm bis etwa 5 µm transparent und weisen in diesem Bereich keine Absorption auf. Die Schichten sind in feucht-warmer Atmosphäre sowie gegenüber Säuren und Alkalien haltbar und besitzen eine gute Härte und Haftfestigkeit.

### Beispiel 3:

### Mischung aus Dy₂O₃, Gd₂O₃ und TiO₂

25 Mol % Dy₂O₃, 25 Mol % Gd₂O₃ und 50 Mol % Titandioxid werden innig miteinander vermischt und anschließend zu Tabletten geformt. Diese werden an Luft bei etwa 1500 °C 6 Stunden lang geglüht. Die Tabletten werden anschließend in eine Aufdampfanlage mit Elektronenstrahl-Verdampfereinrichtung vom Typ L560 der Fa. Leybold eingebracht und bei Temperaturen von etwa 2000°C und einem Sauerstoffdruck von 2x10⁻² Pa verdampft. Dabei wird auf den als Substraten in der Apparatur befindlichen Gläsern aus Quarzglas, welche vor der Bedampfung auf etwa 300 °C erhitzt worden waren, eine dünne Schicht abgeschieden. Die Dicke dieser Schicht wird auf etwa 240 nm eingestellt. Nach dem Abkühlen und der Entnahme aus der Verdampfungsapparatur werden die Transmissions- und Reflexionsspektren der beschichteten Gläser mit einem Spektralphotometer gemessen. Aus den Spektren wird die Brechzahl der Schicht ermittelt. Es werden homogene Schichten erhalten, welche bei einer Wellenlänge von 500 nm eine Brechzahl von 2,2 aufweisen.
Die Schichten sind im Spektralbereich von 400 nm bis etwa 5 µm transparent und weisen in diesem Bereich keine Absorption auf. Die Schichten sind in feucht-warmer Atmosphäre sowie gegenüber Säuren und Alkalien haltbar und besitzen eine gute Härte und Haftfestigkeit.

### Beispiel 4:

### Mischung aus Gd₂O₃, TiO₂ und Ti

Aus einer homogenen Mischung aus 83,45 Gew. % Gd₂O₃, 13,79 Gew. % Titandioxid und 2,76 Gew. % Titan werden Tabletten hergestellt und diese nachfolgend im Vakuum bei einem Druck von 1x10⁻¹ Pa bei etwa 1600 °C 10 Stunden lang geglüht.

Die Tabletten werden anschließend in eine Aufdampfanlage mit Elektronenstrahl-Verdampfereinrichtung vom Typ L560 der Fa. Leybold eingebracht und bei Temperaturen von etwa 1800°C und einem Sauerstoffdruck von 2x10⁻² Pa verdampft. Dabei wird auf den als Substraten in der Apparatur befindlichen Gläsern aus Quarzglas, welche vor der Bedampfung auf etwa 300 °C erhitzt worden waren, eine dünne Schicht abgeschieden. Die Dicke dieser Schicht wird auf etwa 220 nm eingestellt. Nach dem Abkühlen und der Entnahme aus der Verdampfungsapparatur werden die Transmissions- und Reflexionsspektren der beschichteten Gläser mit einem Spektralphotometer gemessen. Aus den Spektren wird die Brechzahl der Schicht ermittelt. Es werden homogene Schichten erhalten, welche bei einer Wellenlänge von 500 nm eine Brechzahl von 2,2 aufweisen.
Die Schichten sind im Spektralbereich von 400 nm bis etwa 5 µm transparent und weisen in diesem Bereich keine Absorption auf. Die Schichten sind in feucht-warmer Atmosphäre sowie gegenüber Säuren und Alkalien haltbar und besitzen eine gute Härte und Haftfestigkeit.

## Patentansprüche

1. Verwendung eines Aufdampfmaterials enthaltend Titanoxid und Gadoliniumoxid und/oder Dysprosiumoxid zur Herstellung von hochbrechenden optischen Schichten.

2. Verwendung gemäß Anspruch 1, **dadurch gekennzeichnet, dass** das Aufdampfmaterial Titandioxid und Gadoliniumoxid und/oder Dysprosiumoxid enthält.

3. Verwendung gemäß Anspruch 1 oder 2, **dadurch gekennzeichnet, dass** das Aufdampfmaterial Titanoxid und Gadoliniumoxid und/oder Dysprosiumoxid in einem molaren Verhältnis von 4:1 bis 1:4 enthält, wobei sich die jeweils letzte Zahl auf den molaren Anteil von Gadoliniumoxid oder Dysprosiumoxid oder auf die Summe der molaren Anteile aus Gadoliniumoxid und Dysprosiumoxid bezieht.

4. Verwendung gemäß Anspruch 3, **dadurch gekennzeichnet, dass** das Aufdampfmaterial Titanoxid und Gadoliniumoxid und/oder Dysprosiumoxid in einem molaren Verhältnis von 2,6:1 bis 1:1,3 enthält, wobei sich die jeweils letzte Zahl auf den molaren Anteil von Gadoliniumoxid oder Dysprosiumoxid oder auf die Summe der molaren Anteile aus Gadoliniumoxid und Dysprosiumoxid bezieht.

5. Verwendung gemäß einem oder mehreren der Ansprüche 1 bis 4, **dadurch gekennzeichnet, dass** das Aufdampfmaterial ein Gemisch aus Gadoliniumoxid und Dysprosiumoxid in einem Verhältnis von 1:99 bis 99:1 enthält.

6. Verwendung gemäß einem oder mehreren der Ansprüche 1 bis 4, **dadurch gekennzeichnet, dass** das Aufdampfmaterial Titandioxid, Titan und Gadoliniumoxid und/oder Dysprosiumoxid enthält.

7. Verwendung gemäß Anspruch 6, **dadurch gekennzeichnet, dass** das Aufdampfmaterial Gadoliniumoxid und Dysprosiumoxid in einem Verhältnis von 1:99 bis 99:1 enthält.

8. Verwendung gemäß einem oder mehreren der Ansprüche 1 bis 7, **dadurch gekennzeichnet, dass** das Aufdampfmaterial 50 bis 92 Gewichtsteile Gadoliniumoxid und/oder Dysprosiumoxid, 7 bis 42 Gewichtsteile Titandioxid und 0 bis 8 Gewichtsteile Titan, bezogen auf das Gesamtgewicht der Mischung, enthält.

9. Verwendung gemäß Anspruch 8, **dadurch gekennzeichnet, dass** das Aufdampfmaterial 50 bis 92 Gewichtsteile Dysprosiumoxid, 7 bis 42 Gewichtsteile Titandioxid und 0 bis 8 Gewichtsteile Titan, bezogen auf das Gesamtgewicht der Mischung, enthält.

10. Verwendung gemäß einem oder mehreren der Ansprüche 1 bis 8, **dadurch gekennzeichnet, dass** das Aufdampfmaterial 67 bis 76 Gewichtsteile Gadoliniumoxid und/oder Dysprosiumoxid, 15 bis 27 Gewichtsteile Titandioxid und 2 bis 5 Gewichtsteile Titan, bezogen auf das Gesamtgewicht der Mischung, enthält.

11. Verwendung gemäß Anspruch 10, **dadurch gekennzeichnet, dass** das Aufdampfmaterial 67 bis 76 Gewichtsteile Dysprosiumoxid, 15 bis 27 Gewichtsteile Titandioxid und 2 bis 5 Gewichtsteile Titan, bezogen auf das Gesamtgewicht der Mischung, enthält.

12. Aufdampfmaterial enthaltend Titandioxid, Titan und Gadoliniumoxid und/oder Dysprosiumoxid.

13. Aufdampfmaterial gemäß Anspruch 12, enthaltend Gadoliniumoxid und Dysprosiumoxid in einem Verhältnis von 1:99 bis 99:1.

14. Aufdampfmaterial gemäß Anspruch 12 oder 13, enthaltend 50 bis 92 Gewichtsteile Gadoliniumoxid und/oder Dysprosiumoxid, 7 bis 42 Gewichtsteile Titandioxid und 2 bis 8 Gewichtsteile Titan, bezogen auf das Gesamtgewicht der Mischung.

15. Aufdampfmaterial gemäß Anspruch 14, enthaltend 50 bis 92 Gewichtsteile Dysprosiumoxid, 7 bis 42 Gewichtsteile Titandioxid und 2 bis 8 Gewichtsteile Titan, bezogen auf das Gesamtgewicht der Mischung.

16. Aufdampfmaterial gemäß einem oder mehreren der Ansprüche 12 bis 14, enthaltend 67 bis 76 Gewichtsteile Gadoliniumoxid und/oder Dysprosiumoxid, 15 bis 27 Gewichtsteile Titandioxid und 2 bis 5 Gewichtsteile Titan, bezogen auf das Gesamtgewicht der Mischung.

17. Aufdampfmaterial gemäß Anspruch 16, enthaltend 67 bis 76 Gewichtsteile Dysprosiumoxid, 15 bis 27 Gewichtsteile Titandioxid und 2 bis 5 Gewichtsteile Titan, bezogen auf das Gesamtgewicht der Mischung.

18. Verfahren zur Herstellung eines Aufdampfmaterials gemäß einem oder mehreren der Ansprüche 12 bis 17, wobei Titanoxid mit Gadoliniumoxid und/oder Dysprosiumoxid gemischt, die Mischung komprimiert oder suspendiert, geformt und anschließend gesintert wird, wobei der Mischung zusätzlich Titan zugesetzt wird.

19. Verfahren gemäß Anspruch 18, wobei das Sintern unter Lufteinfluss stattfindet.

20. Verfahren gemäß Anspruch 18, wobei das Sintern im Vakuum stattfindet.

21. Verfahren gemäß Anspruch 18, wobei das Sintern unter Inertgas stattfindet.

22. Verfahren gemäß Anspruch 18, wobei die Mischung zu Tabletten, Scheiben, Pellets, Kegelstümpfen, Körnern. Granulaten, Stangen oder Kugeln geformt wird.

23. Mehrlagiges optisches System, umfassend mindestens eine hochbrechende optische Schicht mit einer Brechzahl von n ≥ 2,0, enthaltend ein Aufdampfmaterial enthaltend Titanoxid und Gadoliniumoxid und/oder Dysprosiumoxid.

## Claims

1. Use of a vapour-deposition material comprising titanium oxide and gadolinium oxide and/or dysprosium oxide for the production of high-refractive-index optical layers.

2. Use according to Claim 1, **characterised in that** the vapour-deposition material comprises titanium dioxide and gadolinium oxide and/or dysprosium oxide.

3. Use according to Claim 1 or 2, **characterised in that** the vapour-deposition material comprises titanium oxide and gadolinium oxide and/or dysprosium oxide in a molar ratio of 4:1 to 1:4, where the respective last number relates to the molar proportion of gadolinium oxide or dysprosium oxide or to the sum of the molar proportions of gadolinium oxide and dysprosium oxide.

4. Use according to Claim 3, **characterised in that** the vapour-deposition material comprises titanium oxide and gadolinium oxide and/or dysprosium oxide in a molar ratio of 2.6:1 to 1:1.3, where the respective last number relates to the molar proportion of gadolinium oxide or dysprosium oxide or to the sum of the molar proportions of gadolinium oxide and dysprosium oxide.

5. Use according to one or more of Claims 1 to 4, **characterised in that** the vapour-deposition material comprises a mixture of gadolinium oxide and dysprosium oxide in a ratio of 1:99 to 99:1.

6. Use according to one or more of Claims 1 to 4, **characterised in that** the vapour-deposition material comprises titanium dioxide, titanium and gadolinium oxide and/or dysprosium oxide.

7. Use according to Claim 6, **characterised in that** the vapour-deposition material comprises gadolinium oxide and dysprosium oxide in a ratio of 1:99 to 99:1.

8. Use according to one or more of Claims 1 to 7, **characterised in that** the vapour-deposition material comprises 50 to 92 parts by weight of gadolinium oxide and/or dysprosium oxide, 7 to 42 parts by weight of titanium dioxide and 0 to 8 parts by weight of titanium, based on the total weight of the mixture.

9. Use according to Claim 8, **characterised in that** the vapour-deposition material comprises 50 to 92 parts by weight of dysprosium oxide, 7 to 42 parts by weight of titanium dioxide and 0 to 8 parts by weight of titanium, based on the total weight of the mixture.

10. Use according to one or more of Claims 1 to 8, **characterised in that** the vapour-deposition material comprises 67 to 76 parts by weight of gadolinium oxide and/or dysprosium oxide, 15 to 27 parts by weight of titanium dioxide and 2 to 5 parts by weight of titanium, based on the total weight of the mixture.

11. Use according to Claim 10, **characterised in that** the vapour-deposition material comprises 67 to 76 parts by weight of dysprosium oxide, 15 to 27 parts by weight of titanium dioxide and 2 to 5 parts by weight of titanium, based on the total weight of the mixture.

12. Vapour-deposition material comprising titanium dioxide, titanium and gadolinium oxide and/or dysprosium oxide.

13. Vapour-deposition material according to Claim 12, comprising gadolinium oxide and dysprosium oxide in a ratio of 1:99 to 99:1.

14. Vapour-deposition material according to Claim 12 or 13, comprising 50 to 92 parts by weight of gadolinium oxide and/or dysprosium oxide, 7 to 42 parts by weight of titanium dioxide and 2 to 8 parts by weight of titanium, based on the total weight of the mixture.

15. Vapour-deposition material according to Claim 14, comprising 50 to 92 parts by weight of dysprosium oxide, 7 to 42 parts by weight of titanium dioxide and 2 to 8 parts by weight of titanium, based on the total weight of the mixture.

16. Vapour-deposition material according to one or more of Claims 12 to 14, comprising 67 to 76 parts by weight of gadolinium oxide and/or dysprosium oxide, 15 to 27 parts by weight of titanium dioxide and 2 to 5 parts by weight of titanium, based on the total weight of the mixture.

17. Vapour-deposition material according to Claim 16, comprising 67 to 76 parts by weight of dysprosium oxide, 15 to 27 parts by weight of titanium dioxide and 2 to 5 parts by weight of titanium, based on the total weight of the mixture.

18. Process for the preparation of a vapour-deposition material according to one or more of Claims 12 to 17, where titanium oxide is mixed with gadolinium oxide and/or dysprosium oxide, the mixture is compressed or suspended, shaped and subsequently sintered, where titanium is additionally added to the mixture.

19. Process according to Claim 18, in which the sintering is carried out with inflow of air.

20. Process according to Claim 18, in which the sintering is carried out in vacuo.

21. Process according to Claim 18, in which the sintering is carried out under an inert gas.

22. Process according to Claim 18, in which the mixture is shaped into tablets, discs, pellets, truncated cones, grains, granules, rods or spheres.

23. Multilayered optical system including at least one high-refractive-index optical layer having a refractive index of n ≥ 2.0, comprising a vapour-deposition material comprising titanium oxide and gadolinium oxide and/or dysprosium oxide.

## Revendications

1. Utilisation d'un matériau de métallisation sous vide comprenant de l'oxyde de titane et de l'oxyde de gadolinium et/ou de l'oxyde de dysprosium, pour la production de couches optiques à haut indice de réfraction.

2. Utilisation selon la revendication 1, **caractérisée en ce que** le matériau de métallisation sous vide comprend de l'oxyde de titane et de l'oxyde de gadolinium et/ou de l'oxyde de dysprosium.

3. Utilisation selon la revendication 1 ou 2, **caractérisée en ce que** le matériau de métallisation sous vide comprend de l'oxyde de titane et de l'oxyde de gadolinium et/ou de l'oxyde de dysprosium selon un rapport molaire de 4:1 à 1:4, où le dernier chiffre respectif concerne la proportion molaire d'oxyde de gadolinium ou d'oxyde de dysprosium ou la somme des proportions molaires d'oxyde de gadolinium et d'oxyde de dysprosium.

4. Utilisation selon la revendication 3, **caractérisée en ce que** le matériau de métallisation sous vide comprend de l'oxyde de titane et de l'oxyde de gadolinium et/ou de l'oxyde de dysprosium selon un rapport molaire de 2,6:1 à 1:1,3, où le dernier chiffre respectif concerne la proportion molaire d'oxyde de gadolinium ou d'oxyde de dysprosium ou la somme des proportions molaires d'oxyde de gadolinium et d'oxyde de dysprosium.

5. Utilisation selon l'une ou plusieurs parmi les revendications 1 à 4, **caractérisée en ce que** le matériau de métallisation sous vide comprend un mélange d'oxyde de gadolinium et d'oxyde de dysprosium selon un rapport de 1:99 à 99:1.

6. Utilisation selon l'une ou plusieurs parmi les revendications 1 à 4, **caractérisée en ce que** le matériau de métallisation sous vide comprend du dioxyde de titane, du titane et de l'oxyde de gadolinium et/ou de l'oxyde de dysprosium.

7. Utilisation selon la revendication 6, **caractérisée en ce que** le matériau de métallisation sous vide comprend de l'oxyde de gadolinium et de l'oxyde de dysprosium selon un rapport de 1:99 à 99:1.

8. Utilisation selon l'une ou plusieurs parmi les revendications 1 à 7, **caractérisée en ce que** le matériau de métallisation sous vide comprend 50 à 92 parties en poids d'oxyde de gadolinium et/ou d'oxyde de dysprosium, 7 à 42 parties en poids de dioxyde de titane et 0 à 8 parties en poids de titane, par rapport au poids total du mélange.

9. Utilisation selon la revendication 8, **caractérisée en ce que** le matériau de métallisation sous vide comprend 50 à 92 parties en poids d'oxyde de dysprosium, 7 à 42 parties en poids de dioxyde de titane et 0 à 8 parties en poids de titane, par rapport au poids total du mélange.

10. Utilisation selon l'une ou plusieurs parmi les revendications 1 à 8, **caractérisée en ce que** le matériau de métallisation sous vide comprend 67 à 76 parties en poids d'oxyde de gadolinium et/ou d'oxyde de dysprosium, 15 à 27 parties en poids de dioxyde de titane et 2 à 5 parties en poids de titane, par rapport au poids total du mélange.

11. Utilisation selon la revendication 10, **caractérisée en ce que** le matériau de métallisation sous vide comprend 67 à 76 parties en poids d'oxyde de dysprosium, 15 à 27 parties en poids de dioxyde de titane et 2 à 5 parties en poids de titane, par rapport au poids total du mélange.

12. Matériau de métallisation sous vide comprenant du dioxyde de titane, du titane et de l'oxyde de gadolinium et/ou de l'oxyde de dysprosium.

13. Matériau de métallisation sous vide selon la revendication 12, comprenant de l'oxyde de gadolinium et de l'oxyde de dysprosium selon un rapport de 1:99 à 99:1.

14. Matériau de métallisation sous vide selon la revendication 12 ou 13, comprenant 50 à 92 parties en poids d'oxyde de gadolinium et/ou d'oxyde de dysprosium, 7 à 42 parties en poids de dioxyde de titane et 2 à 8 parties en poids de titane, par rapport au poids total du mélange.

15. Matériau de métallisation sous vide selon la revendication 14, comprenant 50 à 92 parties en poids d'oxyde de dysprosium, 7 à 42 parties en poids de dioxyde de titane et 2 à 8 parties en poids de titane, par rapport au poids total du mélange.

16. Matériau de métallisation sous vide selon l'une ou plusieurs parmi les revendications 12 à 14, comprenant 67 à 76 parties en poids d'oxyde de gadolinium et/ou d'oxyde de dysprosium, 15 à 27 parties en poids de dioxyde de titane et 2 à 5 parties en poids de titane, par rapport au poids total du mélange.

17. Matériau de métallisation sous vide selon la revendication 16, comprenant 67 à 76 parties en poids d'oxyde de dysprosium, 15 à 27 parties en poids de dioxyde de titane et 2 à 5 parties en poids de titane, par rapport au poids total du mélange.

18. Procédé de préparation d'un matériau de métallisation sous vide selon l'une ou plusieurs parmi les revendications 12 à 17, dans lequel on mélange de l'oxyde de titane avec de l'oxyde de gadolinium et/ou de l'oxyde de dysprosium, le mélange est comprimé ou mis en suspension, mis en forme et ensuite fritté, où on ajoute en outre du titane au mélange.

19. Procédé selon la revendication 18, dans lequel le frittage est réalisé avec influx d'air.

20. Procédé selon la revendication 18, dans lequel le frittage est réalisé sous vide.

21. Procédé selon la revendication 18, dans lequel le frittage est réalisé sous un gaz inerte.

22. Procédé selon la revendication 18, dans lequel le mélange est mis en forme de comprimés, de disques, de pastilles, de cônes tronqués, de grains, de granules, de bâtonnets ou de sphères.

23. Système optique multicouches comportant au moins une couche optique à haut indice de réfraction ayant un indice de réfraction n ≥ 2,0, comprenant un matériau de métallisation sous vide comprenant de l'oxyde de titane et de l'oxyde de gadolinium et/ou de l'oxyde de dysprosium.
